# EUROPEAN PATENT SPECIFICATION

(11) **EP 3 018 705 B1**
(45) Date of publication and mention of the grant of the patent: **22.08.2018**
(21) Application number: 14191680.9
(22) Date of filing: 04.11.2014
(51) Int. Cl.: H01L 23/00

(54) **An apparatus and associated methods for mounting electronic components on deformable substrates**
Vorrichtung und zugehörige Verfahren zur Montage von elektronischen Komponenten auf verformbare Substrate
Appareil et procédés associés pour monter des composants électroniques sur des substrats déformables

(43) Date of publication of application: 11.05.2016
(73) Proprietor: Nokia Technologies Oy, 02610 Espoo (FI)
(72) Inventor: White, Richard, Huntingdon, GB PE28 9DY (GB); Haque,, Samiul, Cambridge, CB4 1GN (GB); Astley, Michael, Waterbeach, CB25 9HP (GB)
(74) Representative: Potter Clarkson LLP

(56) References cited:
- EP-A1- 2 264 831
- US-B1- 8 614 506

## Description

### Technical Field

The present disclosure relates to the field of electronic components mounted on deformable substrates, associated methods, computer programs and apparatus. Certain disclosed aspects/examples relate to portable electronic devices, in particular, so-called hand-portable electronic devices which may be hand-held in use (although they may be placed in a cradle in use). Such hand-portable electronic devices include so-called Personal Digital Assistants (PDAs), navigation devices, mobile telephones, smartphones and other smart devices, smartwatches and tablet PCs.

### Background

An electronic component may be mounted on a deformable substrate. An example is disclosed in US8614506.

### Summary

In a first aspect there is provided an apparatus comprising: a deformable substrate, the substrate configured to allow for electrical connection of one or more substrate electronic components mounted on the deformable substrate to at least one of: one or more other electronic components mounted on the deformable substrate, and one or more other electronic components mounted on another connected substrate; and one or more substrate electronic components mounted on the deformable substrate by an interconnect, the interconnect configured to electrically and mechanically interconnect the one or more substrate electronic components to the deformable substrate; wherein the interconnect comprises an ion gel, the ion gel configured to: electrically interconnect the one or more substrate electronic components to the deformable substrate by capacitive coupling; mechanically interconnect the one or more substrate electronic components to the deformable substrate by adhesion, and maintain the electrical and mechanical interconnection of the one or more substrate electronic components under operational strains of the deformable substrate.

The use of an ion gel as an interconnect may advantageously enable an electronic device to be flexible while maintaining robust electrical and mechanical connections between component parts. Use of ion gels may advantageously enable construction of devices without the need for application of heat and/or high pressures in order to interconnect electronic components to deformable substrates. Thus, surface mount technology may be advantageously applied to the field of flexible electronics.

One or more of the electrical interconnect and the deformable substrate may be configured to accommodate strains of up to 5%, 10%, 15%, 20%, 25%, 30%, 40%, 50%, 75%, 100%, 150% or 200% under operational conditions.

The operational strains may comprise one or more of: flexure providing for a radius of curvature of at least a portion of the deformable substrate, the radius of curvature being less than 10mm, 15mm, 20mm, 25mm, 30mm, 35mm, 40mm, 45mm, 50mm, 55mm and 60mm up to 300mm; stretching of at least a portion of the deformable substrate, the stretching being up to 5%, 10%, 15%, 25%, 30% of the un-stretched length of the deformable substrate; and compression of at least a portion of the deformable substrate, the compression being up to 5%, 10%, 15%, 25%, 30% of the uncompressed length of the deformable substrate.

The deformable substrate may comprise at least one surface recess, the at least one surface recess configured to facilitate operational strains of the deformable substrate by respective opening and closing of the at least one surface recess under operational strains. Inclusion of surface recesses in the design of a deformable substrate may advantageously increase the flexibility of the deformable substrate while improving the resilience of the deformable substrate to repeated operational strains.

The ion gel may be configured to span from a first side of the surface recess to the second opposing side of the surface recess. Thereby, in certain embodiments, the ion gel may enable connection of an electrical component on one side of the surface recess to an electrical contact on the deformable substrate situated on the opposing side of the surface recess. Also, an interconnect can still be conveniently provided over a surface recess.

The ion gel may be configured to one of at least partially infill the surface recess or span across the surface recess without partially infilling the surface recess.

One or more of a region of the deformable substrate underlying the substrate electronic component and the substrate electronic component as well as the ion gel interconnect may be at least partially, or fully, optically transparent.

The deformable substrate may comprise an electrically conductive track configured to enable the electrical connection, the electrically conductive track comprising one or more of graphene and carbon nanotubes. Use of graphene and/or carbon nanotubes may advantageously enable electrical connections within the deformable substrate while maintaining both the flexibility of the substrate and the optical transparency of the substrate.

The ion gel may comprise an ionic liquid and a polymer, the ionic liquid comprising one or more of 1-ethyl-3-methylimidazolium bis(trifluoromethylsulfonyl)imide, [EMIM][TFSI], [BMIM][PF6], and [EMIM][OctOSO3, and the polymer comprising one or more of PS PMMA PS triblock copolymer and PS-PEO-PS (which is triblock copolymer, poly(styrene-block-ethylene oxide-block-styrene)).

The ion gel may have one or more of: a viscosity in the range of 1 mPas to 10000 cPas under operational conditions; an adhesive shear strength sufficient to provide resilient functioning of an example apparatus embodiment of the present disclosure under operational conditions; and an adhesive pull strength sufficient to provide resilient functioning of an example apparatus embodiment of the present disclosure under operational conditions. The ion gel may be diluted to reach various conditions for various applications. In some examples inkjet printing may be used to form an ion gel interconnect with a viscosity in the range of 8-20mPas. In some examples other printing techniques maybe used as well. Dispensing and spraying maybe used for coating ion gel liquid onto various substrates.

The electrical interconnection of the ion gel to the deformable substrate or the substrate electronic component may comprise a specific capacitance greater than 1µF/cm², up to 50µF/cm² or even up to 300µF/cm².

The substrate electronic component may comprise one or more of: a sensor configured to provide sensor signalling based on the electrical impedance of the sensor; a rectifier configured to receive alternating current from the interconnect by capacitive coupling and to provide direct current to an electronic component.

There may be provided a substrate interconnect, the substrate interconnect configured to electrically and mechanically interconnect another substrate to the deformable substrate, wherein the substrate interconnect may comprise an ion gel, the ion gel configured to: electrically interconnect the other substrate to the deformable substrate by capacitive coupling; mechanically interconnect the other substrate to the deformable substrate by adhesion, and maintain the electrical and mechanical interconnection of the respective substrates under operational strains of one or more of the deformable substrate and the other substrate.

The substrate interconnect and the component interconnect may comprise the same or similar ion gels.

The apparatus may be a portable electronic device, an electronic device, or a module for one or more of the same.

According to a further aspect there is provided a method comprising: providing an apparatus by mounting one or more substrate electronic components to a deformable substrate by using an ion gel interconnect, the ion gel interconnect configured to electrically and mechanically interconnect the one or more substrate electronic components to the deformable substrate, wherein the substrate is configured to allow for electrical connection of the one or more substrate electronic components mounted on the deformable substrate to at least one of: one or more other electronic components mounted on the deformable substrate, and one or more other electronic components mounted on another connected substrate; and the ion gel is configured to: electrically interconnect the one or more substrate electronic components to the deformable substrate by capacitive coupling; mechanically interconnect the one or more substrate electronic components to the deformable substrate by adhesion, and maintain the electrical and mechanical interconnection of the one or more substrate electronic components under operational strains of the deformable substrate.

According to a further aspect, there is provided a computer program, the computer program comprising computer code to provide an apparatus by mounting one or more substrate electronic components to a deformable substrate by using an ion gel interconnect, the ion gel interconnect configured to electrically and mechanically interconnect the one or more substrate electronic components to the deformable substrate, wherein the substrate is configured to allow for electrical connection of the one or more substrate electronic components mounted on the deformable substrate to at least one of: one or more other electronic components mounted on the deformable substrate, and one or more other electronic components mounted on another connected substrate; and the ion gel is configured to: electrically interconnect the one or more substrate electronic components to the deformable substrate by capacitive coupling; mechanically interconnect the one or more substrate electronic components to the deformable substrate by adhesion, and maintain the electrical and mechanical interconnection of the one or more substrate electronic components under operational strains of the deformable substrate.

One or more of the computer programs may, when run on a computer, cause the computer to configure any apparatus, including a battery, circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

The steps of any method disclosed herein do not have to be performed in the exact order disclosed, unless explicitly stated or understood by the skilled person.

Corresponding computer programs (which may or may not be recorded on a carrier) for implementing one or more of the methods disclosed herein are also within the present disclosure and encompassed by one or more of the described example embodiments.

The present disclosure includes one or more corresponding aspects, examples or features in isolation or in various combinations whether or not specifically stated (including claimed) in that combination or in isolation. Corresponding means and corresponding functional units or performing one or more of the discussed functions are also within the present disclosure.

The above summary is intended to be merely exemplary and non-limiting.

### Brief Description of the Figures

A description is now given, by way of example only, with reference to the accompanying drawings, in which:
Figure 1 illustrates an example apparatus embodiment comprising a substrate electronic component interconnected to a deformable substrate;
Figure 2 illustrates a cross-section view of an electronic component interconnected to a deformable substrate in which the substrate is deformed into a curved configuration;
Figure 3a illustrates a cross-section view of a deformable substrate with a surface recess;
Figure 3b illustrates a cross-section view of the deformable substrate of figure 3a undergoing a deformation;
Figure 4a illustrates a cross-section view of a deformable substrate with a surface recess and an ion gel interconnect configured to span the surface recess without infilling;
Figure 4b illustrates a cross-section view of the deformable substrate of figure 4a undergoing a deformation;
Figure 5a illustrates a cross-section view of a deformable substrate with a surface recess and an ion gel interconnect configured to span the surface recess with partial infilling of the surface recess;
Figure 5b illustrates a cross-section view of the deformable substrate of figure 5a undergoing a deformation;
Figure 6 illustrates a plan view of a deformable substrate, ion gel interconnect and substrate electronic component that are at least partially transparent;
Figure 7a illustrates a cross-section view of an ion gel interconnect coupled to two conductive elements and thereby configured to form a double-layer capacitor;
Figure 7b illustrates experimental data showing the relationship between the specific capacitance of an arrangement such as shown in figure 7a and frequency of an applied electric field;
Figure 8a illustrates a schematic representation of the impedance of a capacitive sensor mounted on a deformable substrate by ion gel interconnects;
Figure 8b illustrates a schematic representation of the impedance of a resistive sensor mounted on a deformable substrate by ion gel interconnects;
Figure 9 illustrates a substrate mounted on a deformable substrate by an ion gel interconnect;
Figure 10 illustrates a flowchart according to a method of the present disclosure; and
Figure 11 illustrates schematically a computer readable medium providing a program.

### Description of Example Aspects

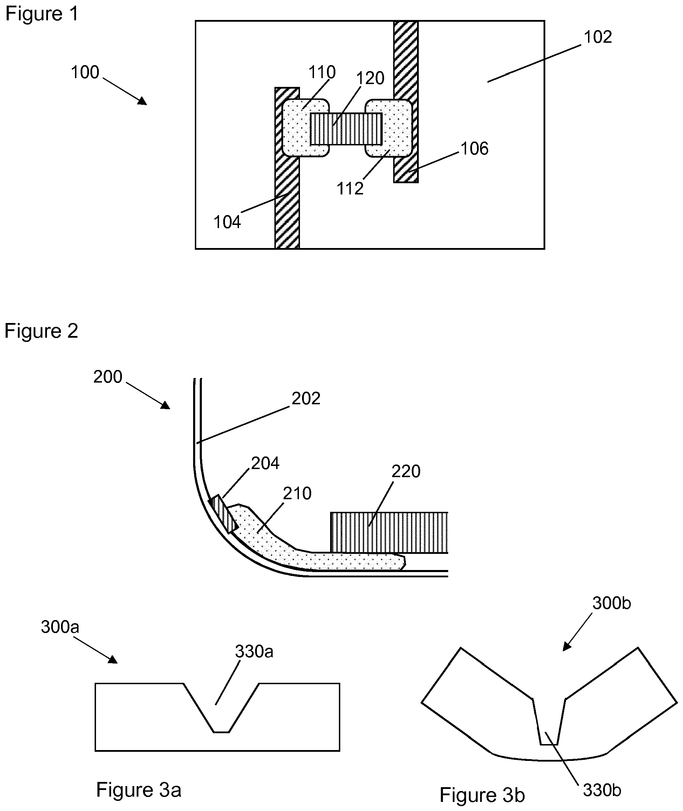

Certain embodiments disclosed herein may be considered to provide an apparatus 100, as illustrated in figure 1, comprising a deformable substrate 102 with a first conductive track 104 and a second conductive track 106, and a substrate electronic component 120 interconnected to the deformable substrate 102 by a first ion gel interconnect 110 and a second ion gel interconnect 112. Of course, in other embodiments, the component 120 may be connected to a single conducting track or to many different conductive tracks by respective use of one or more ion gel interconnects.

Generally, an apparatus may comprise: a deformable substrate, the substrate configured to allow for electrical connection of one or more substrate electronic components mounted on the deformable substrate to at least one of: one or more other electronic components mounted on the deformable substrate, and one or more other electronic components mounted on another connected substrate. Such electrical connections may be provided for by electrically conducting tracks formed in the substrate. One or more substrate electronic components may be mounted on the deformable substrate by an interconnect, the interconnect configured to electrically and mechanically interconnect the one or more substrate electronic components to the deformable substrate. The interconnect must therefore be capable of undergoing such deformations as may be necessary to accommodate the deformations of the deformable substrate while maintaining, at least partially, if not substantially fully, the operational integrity of the both mechanical and electrical connections between the substrate and the mounted substrate electronic component.

In some cases, prior art interconnects can be used for some connections. However, according to the present disclosure, at least one of the interconnects may comprise an ion gel, the ion gel configured to: electrically interconnect the one or more substrate electronic components to the deformable substrate by capacitive coupling; mechanically interconnect the one or more substrate electronic components to the deformable substrate by adhesion, and maintain the electrical and mechanical interconnection of the one or more substrate electronic components under operational strains of the deformable substrate.

The operational strains may comprise one or more of tensile, normal, compressive and shearing strain when the deformable substrate undergoes corresponding operational deformation.

The properties of ion gels may enable them to provide excellent interconnect characteristics. An ion gel may provide effective mechanical interconnection between a substrate and an electronic component by virtue of its adhesive properties and its intrinsic mechanical flexibility; this flexibility may enable the ion gel to distort to accommodate operational strains of the deformable substrate while maintaining a robust mechanical connection between the substrate and the mounted electronic device.

Where an ion gel interconnect is disposed on an electrically conductive track provided in the deformable substrate, the ion gel may form a double-layer capacitance at the interface between the ion gel and the electrically conductive track. Similarly, where the ion gel interconnect is coupled to an electrical contact provided as part of a substrate electronic device, the ion gel may also form a double layer capacitance at the interface between the interconnect and the electrical contact. Generally, double layer capacitors are well known to persons skilled in the art of capacitor design. By forming a double layer capacitor, with an ion gel interconnect disposed between a deformable substrate and an electronic device, the device may be capacitively coupled to the substrate. Thereby, an alternating current may be supplied from the substrate to the electronic device.

An electrical circuit may be completed by providing a second ion gel interconnect 112 between the substrate electronic device 120 and a second electrically conductive track 106 within the substrate 102, as illustrated in figure 1. It will be appreciated that in other examples a plurality of electrical tracks embedded in a deformable substrate may be capacitively coupled to a substrate electronic component by a plurality of respective ion gel interconnects. Such a plurality of electrical circuits may provide electrical power to the electronic component and may also provide for electrical signalling, both from the substrate to the electronic component and from the electronic component to the substrate. The signalling may be exchanged between the substrate and any electronic device; the electronic device may thereby exchange signalling with the substrate electronic component.

One or more of the electrical interconnect and the deformable substrate may be configured to accommodate strains of up to 5%, 10%, 15%, 20%, 25%, 30%, 40%, 50%, 75%, 100%, 150% or 200% under operational conditions. The electrical interconnect may advantageously be configured to accommodate greater strains than the deformable substrate; thereby, the electrical interconnect may reliably and resiliently provide an electrical connection between the substrate and an electronic component under any possible operational deformation that the substrate may accept.

The operational strains comprise one or more of: flexure providing for a radius of curvature of at least a portion of the deformable substrate, the radius of curvature being less than 10mm, 15mm, 20mm, 25mm, 30mm, 35mm, 40mm, 45mm, 50mm, 55mm and 60mm up to 300mm; stretching of at least a portion of the deformable substrate, the stretching being up to 0.5% to a few %, 1%, 2%, 3%, 4%, 5%, 10%, 15%, 25%, 30% of the un-stretched length of the deformable substrate; and compression of at least a portion of the deformable substrate, the compression being up to 5%, 10%, 15%, 25%, 30% of the uncompressed length of the deformable substrate.

Figure 2 shows a cross section view of an apparatus 200 comprising a deformable substrate 202 undergoing a deformation away from an un-deformed flat state to a deformed curved state. The apparatus 200 further comprises an electronic component 220 that is interconnected to the deformable substrate 202 by an ion gel interconnect 210. The ion gel interconnect enables an electrical connection to be made, by capacitive coupling, between the electronic component 220 and an electrically conducting track 204 embedded in the deformable substrate 202. The mechanical flexibility of the ion gel interconnect 210 enables it to deform along with the deformable substrate 202 such that the electrical interconnection can be maintained during the operational deformation. It will be appreciated that any other type of elastic deformation of the deformable substrate may also be accommodated by the mechanical flexibility of a suitable ion gel.

In some examples the deformable substrate may comprise at least one surface recess, the at least one surface recess configured to facilitate operational strains of the deformable substrate by respective opening and closing of the at least one surface recess under operational strains.

Figure 3a illustrates an example of a portion of a deformable substrate 300a having a surface recess 330a configured to facilitate operational strains of the deformable substrate 300a. The surface recess 330a comprises a depression, wherein the thickness of the deformable substrate 300a is reduced; the reduced thickness enables deformation of the substrate to occur more readily, thereby facilitating operational strains of the substrate.

Figure 3b shows the deformable substrate 300b of figure 3a undergoing a deformation facilitated by closing of the surface recess 330b. It will be appreciated that a deformable substrate may undergo deformations in which a surface recess opens in order to facilitate flexing in a direction opposite to that illustrated in figure 3b.

In some examples, a regular array of surface recesses may be formed in a deformable substrate in order to facilitate a range of different deformations in which the substrate may flex in variety of different directions. For example, a first plurality of substantially straight parallel recesses may be formed while a second plurality of substantially straight parallel recesses may be formed at an angle to the first plurality of recesses. In other examples the recesses may comprise curved loci disposed across the surface of the deformable substrate.

In some examples, ion gel may be configured to span from a first side of the surface recess to a second opposing side of the surface recess.

In some examples the ion gel may be configured to one of at least partially infill the surface recess or span across the surface recess without partially infilling the surface recess.

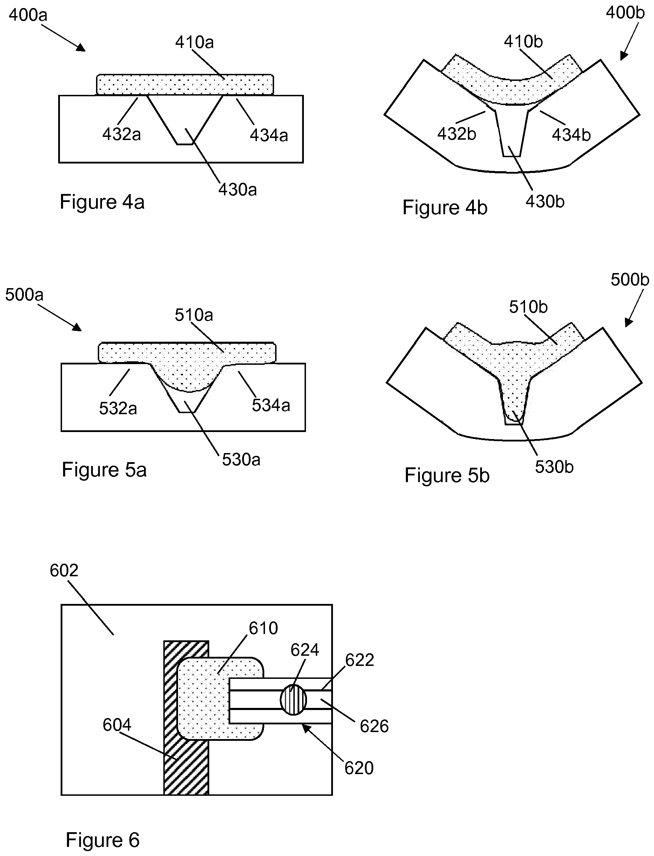

Figure 4a illustrates an example where a portion of a deformable substrate 400a has a surface recess 430a. The deformable substrate 400a may be considered to have a first side 432a with respect to the surface recess 430a and a second side 434a on the opposing side of the surface recess 430a. An ion gel interconnect 410a may be coupled to both the first side 432a and the second side 434a of the deformable substrate 400a and thereby span across the surface recess 430a. In figure 4a it can be seen that the ion gel 410a does not even partially infill the surface recess 430a.

Figure 4b illustrates an example where the deformable substrate 400b of figure 4a has been deformed into a curved configuration. The ion gel 410b may readily accommodate the deformation by elastically deforming into an appropriate curved shape, while maintaining a secure connection to the deformable substrate 400b on both the first side 432b and the second side 434b of the surface recess 430b, which can be seen to have closed somewhat in order to facilitate the deformation of the deformable substrate 400b. In this example, it can be seen that the ion gel 410b does not infill the surface recess 430b even when the deformable substrate 400b is deformed. In certain embodiments, depending for example on the relative flexibility of the ion gel, by not infilling the surface recess 430b, the configuration of ion gel 410b may enable the surface recess 430b to facilitate operational strains of the deformable substrate 400b to a greater extent than where some infilling occurred.

In some examples, illustrated by figure 5a, a deformable substrate 500a, similar to the deformable substrate 400a of figure 4a, may have an ion gel interconnect 510a coupled to both a first side 532a and a second side 534a of a surface recess 530a, wherein the ion gel 510a does at least partially infill the surface recess 530a. In certain embodiments, for example depending on the flexibility, stiffness or adhesiveness of the ion gel, partially infilling of the surface recess 530a may enable greater adhesion of the ion gel 510a to the deformable substrate 500a than would be possible where no infilling occurred.

Figure 5b illustrates an example where a deformable substrate 500b, similar to the deformable substrate 400b of figure 4b, is undergoing an operational deformation into a curved configuration. In this example, it can be seen that the ion gel 510b further infills the surface recess 530b as the surface recess 530b closes to accommodate the operational strain of the deformable substrate 500b. It will be appreciated that, through an appropriate choice of ion gel configuration and surface recess configuration a deformable substrate may be configured to accommodate desired operational strains.

In some examples, one or more of a region of the deformable substrate underlying the substrate electronic component and the substrate electronic component as well as the ion gel interconnect may be at least partially optically transparent. Partial optical transparency, or translucency, may mean that only a certain proportion of visible light is transmitted through a particular component. In some examples partial transparency may also mean that parts of a component are transparent while others are not transparent.

Figure 6 illustrates part of a deformable substrate 602 with a substrate electronic component 620 mounted on the deformable substrate 602 by an ion gel 610 interconnect. Any one of the deformable substrate 602, the substrate electronic component 620 and the ion gel interconnect 610 may be optically transparent, when comprised of suitable materials. In some examples, a particular part of the substrate electronic component may comprise a conductive metal track 622 that may not be optically transparent. In some examples the substrate electronic component may comprise a sensor 624 which may or may not be transparent, while other portions 626 of the substrate electronic component may be at least partially transparent.

In some examples, the deformable substrate comprises an electrically conductive track 604 configured to enable the electrical connection, the electrically conductive track 604 comprising one or more of graphene and carbon nanotubes. Both graphene and carbon nanotubes may be provided in extremely thin layers that may combine good electrical conductivity with a high degree of flexibility and a substantial degree of optical transparency.

Generally, the ion gel may comprise an ionic liquid and a polymer, the ionic liquid comprising one or more of 1-ethyl-3-methylimidazolium bis(trifluoromethylsulfonyl)imide, [EMIM][TFSI], [BMIM][PF6], and [EMIM][OctOSO3, and the polymer comprising one or more of PS PMMA PS, triblock copolymer and PS-PEO-PS (which is triblock copolymer, poly(styrene-block-ethylene oxide-block-styrene)). Ion gels may be prepared by mixing a suitable polymer with a suitable ionic liquid, often in the presence of a solvent such as acetonitrile (or ethyl acetate). Once a homogeneous mixture has been obtained, the solvent may be removed by a drying process in which the solvent is evaporated away, possibly be heating the mixture. The resulting ion gel comprises a matrix provided by the polymer that locks the molecules of the ionic liquid into a convenient solid state. Ion gel interconnects may be prepared by spin coating the ion gel, to provide a thin uniform layer of ion gel, before cutting the required shape of interconnect out of the spin coated layer. In some examples, it may be possible to print the ion gel directly onto a substrate using printing techniques such as ink-jet printing.

Ion gels may thus be prepared that possess a desirable range of different properties. An ion gel may have a viscosity in the range of 1 mPas to 10000 cPas under operational conditions. An ion gel may have an adhesive shear strength sufficient to provide resilient functioning of an example apparatus embodiment of the present disclosure under operational conditions. An ion gel may have an adhesive pull strength sufficient to provide resilient functioning of an example apparatus embodiment of the present disclosure under operational conditions.

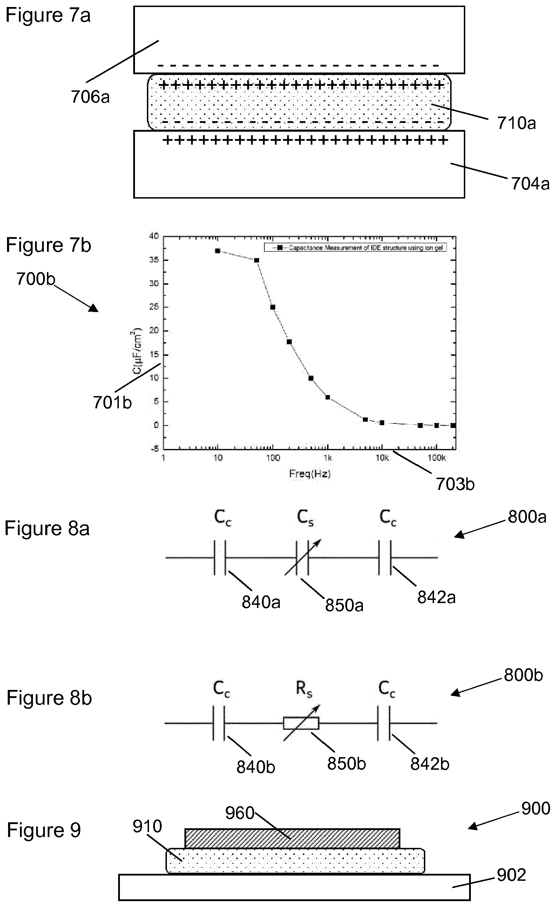

Figure 7a shows an ion gel 710a in contact with a first conducting surface 704a and a second conducting surface 706a. When an electric field is applied to the ion gel 710a, between the first 704a and second 706a conducting surfaces, a double layer capacitor may be formed. Double layer capacitors are known to those skilled in the art of capacitor design, and consist of a layer of, for example, positive charge, situated very close to a first interface and a layer of the opposite, for example negative charge, situated very close to the second interface. The distances involved in the formation of the charged layers may be as short as a few nanometres. This may give rise to very high specific capacitances, that is, capacitances per unit area. Therefore, where ion gels are used to form electrical interconnects between a deformable substrate and a substrate electronic device, a specific capacitance greater than 1 micro Farad per square centimetre, and up to 50 - 300 micro Farads per square centimetre, may be formed. Such capacitances may enable efficient capacitive coupling of electrical power and/or signalling between a deformable substrate and a substrate electronic component mounted on the deformable substrate by an ion gel interconnect.

Figure 7b shows a chart 700b of experimental data showing specific capacitance, plotted on a vertical axis 701b, as a function of frequency, plotted on a horizontal axis 703b, for an ion gel capacitor, with a cross sectional structure as illustrated in figure 7a. The particular ion gel capacitor used to generate the data shown in the chart 700b comprised PS PMMA PS triblock copolymer mixed with ionic liquid 1-ethyl-3-methylimidazolium bis(trifluoromethylsulfonyl)imide ([EMIM][TFSI]). The 21.4mg of the block copolymer was dissolved in 878.7mg of ethylacetate, while 114.7mg of ionic liquid was dissolved in 899.3mg of ethylacetate. After mixing together, the combined solution was evaporated to provide an ion gel suitable for use in certain embodiments of the present disclosure. The finished ion gel comprised approximately 16% weight of the block copolymer and ionic liquid in solution.

To measure specific capacitance, a Metal-Insulator-Metal (MIM) capacitor was prepared comprising a first layer of evaporated gold, approximately 50nm thick, a second layer of the ion gel placed on top of the first layer, and a third layer of evaporated gold placed on top of the ion gel. The total area of the MIM capacitor was approximately 1cm². An LCR meter was then used to measure the capacitance of the MIM capacitor at a range of different frequencies.

It can be seen that the specific capacitance plotted in chart 700b has high levels, in excess of 30 micro Farads per square centimetre at low frequencies, below 100 Hz, and retains significant values of capacitance up to frequencies of tens of kilohertz.

Formation of a double layer capacitance by an ion gel interconnect and a deformable substrate and substrate electronic component may be particularly advantageous as the capacitance of the arrangement will be scarcely changed by deformations of the deformable substrate. Even when the substrate is significantly deformed, provided the area of the interface between a conductive surface and an ion gel interconnect remains the same, the capacitance will remain the same, because curvatures and other deformations will be essentially negligible on the length scale of the interface region within the ion gel. The substrate may experience a radius of curvature of the order of millimetres, but the interface region may extend to only nanometres; consequently the geometry and therefore the magnitude of the of the capacitor may therefore remain effectively unchanged by an operational deformation of the substrate.

Where a substrate electronic component comprises a sensor, it may be configured to provide sensor signalling based on the electrical impedance of the sensor. For example, a sensor may change its capacitance in response to certain sensed stimuli, as in capacitive touch sensors. When such a sensor is mounted on a deformable substrate and interconnected to the substrate by ion gel interconnects, the arrangement 800a may be represented schematically as illustrated in figure 8a. A first capacitor 840a represents the double layer capacitance of a first ion gel interconnect while a second capacitor 842a represents the double layer capacitance of a second ion gel interconnect that completes a circuit. Situated between the two ion gel interconnects, a sensor may be a variable capacitance 850a. Since the two ion gel interconnect capacitances will not change as a result of deformations of the deformable substrate, any changes in the capacitance of the overall arrangement 800a may be attributed to changes in the sensor. Such changes may thereby easily be determined by an electronic device connected to the deformable substrate, without having to account for any changes to the coupling capacitance, such as might occur in other substrate systems.

Figure 8b shows a schematic representation of a sensor arrangement 800b comprising a variable resistance 850b, configured to change in response to some stimulus. In some examples, the stimulus may be temperature. Thereby, an electronic device, connected to such a sensor mounted on a deformable substrate, may be enabled to determine the temperature of the sensor without needing to account for any deformation experienced by the substrate on which the sensor is mounted. More generally, the sensor may comprise an arbitrary electrical impedance, with resistive, capacitive and inductive elements, any of which may change in response to sensed stimuli. In any such case, no correction need be made for operational deformations of the deformable substrate; any changes in impedance of the arrangement may be attributed directly to changes in the sensor alone.

In some examples, the substrate electronic component may comprise a rectifier, configured to receive electrical power in the form of alternating current, via capacitive coupling from ion gel interconnects, and to provide direct current to power an electronic component, such as a Light Emitting Diode (LED) or any other component requiring a direct current power supply.

In some examples 900, there may be provided a substrate interconnect 910, as illustrated in figure 9. The substrate interconnect 910 may be configured to electrically and mechanically interconnect another substrate 960 to the deformable substrate 902, wherein the substrate interconnect 910 comprises an ion gel, the ion gel configured to: electrically interconnect the other substrate 960 to the deformable substrate 902 by capacitive coupling; mechanically interconnect the other substrate 960 to the deformable substrate 902 by adhesion, and maintain the electrical and mechanical interconnection of the respective substrates under operational strains of one or more of the deformable substrate 902 and the other substrate 960.

It will be appreciated that the other substrate 960 may be a deformable substrate, or in other examples the other substrate 960 may be a rigid substrate. Further, it will be appreciated that electronic components may be mounted on the other substrate, and that the other substrate may have any of the characteristics of the deformable substrates disclosed above.

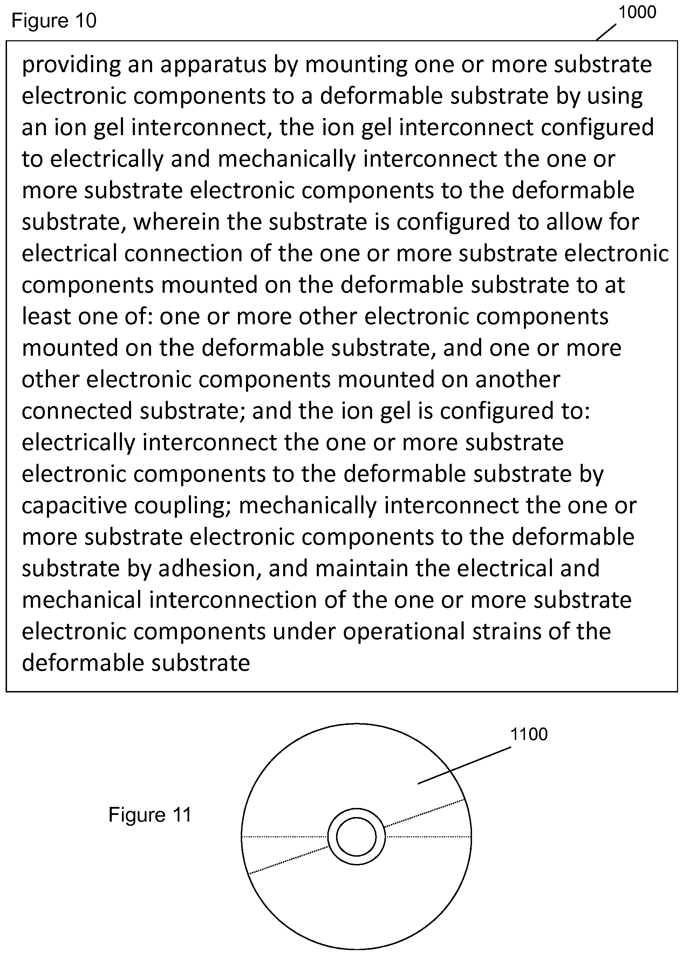

Figure 10 shows a flow diagram illustrating the method 1000 comprising: providing an apparatus by mounting one or more substrate electronic components to a deformable substrate by using an ion gel interconnect, the ion gel interconnect configured to electrically and mechanically interconnect the one or more substrate electronic components to the deformable substrate, wherein the substrate is configured to allow for electrical connection of the one or more substrate electronic components mounted on the deformable substrate to at least one of: one or more other electronic components mounted on the deformable substrate, and one or more other electronic components mounted on another connected substrate; and the ion gel is configured to: electrically interconnect the one or more substrate electronic components to the deformable substrate by capacitive coupling; mechanically interconnect the one or more substrate electronic components to the deformable substrate by adhesion, and maintain the electrical and mechanical interconnection of the one or more substrate electronic components under operational strains of the deformable substrate.

Figure 11 illustrates schematically a computer/processor readable medium 1100 providing a program according to an example. In this example, the computer/processor readable medium is a disc such as a digital versatile disc (DVD) or a compact disc (CD). In other examples, the computer readable medium may be any medium that has been programmed in such a way as to carry out an inventive function. The computer program code may be distributed between the multiple memories of the same type, or multiple memories of a different type, such as ROM, RAM, flash, hard disk, solid state, etc.

The apparatus shown in the above examples may be a portable electronic device, a laptop computer, a mobile phone, a smartphone, a tablet computer, a smart television, a personal digital assistant, a navigation device, a watch, a digital camera, a non-portable electronic device, a server, a desktop computer, a monitor/display, or a module/circuitry for one or more of the same.

Any mentioned apparatus/device/server and/or other features of particular mentioned apparatus/device/server may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/ functional units.

In some examples, a particular mentioned apparatus/device/server may be pre-programmed with the appropriate software to carry out desired operations, and wherein the appropriate software can be enabled for use by a user downloading a "key", for example, to unlock/enable the software and its associated functionality. Advantages associated with such examples can include a reduced requirement to download data when further functionality is required for a device, and this can be useful in examples where a device is perceived to have sufficient capacity to store such pre-programmed software for functionality that may not be enabled by a user.

Any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

Any "computer" described herein can comprise a collection of one or more individual processors/processing elements that may or may not be located on the same circuit board, or the same region/position of a circuit board or even the same device. In some examples one or more of any mentioned processors may be distributed over a plurality of devices.

The same or different processor/processing elements may perform one or more functions described herein.

The term "signalling" may refer to one or more signals transmitted as a series of transmitted and/or received electrical/optical signals. The series of signals may comprise one, two, three, four or even more individual signal components or distinct signals to make up said signalling. Some or all of these individual signals may be transmitted/received by wireless or wired communication simultaneously, in sequence, and/or such that they temporally overlap one another.

With reference to any discussion of any mentioned computer and/or processor and memory (e.g. including ROM, CD-ROM etc.), these may comprise a computer processor, Application Specific Integrated Circuit (ASIC), field-programmable gate array (FPGA), and/or other hardware components that have been programmed in such a way to carry out the inventive function.

## Claims

1. An apparatus comprising:
a deformable substrate (102, 202, 300a, 300b, 400a, 400b, 500a, 500b, 602, 902), the substrate configured to allow for electrical connection of one or more substrate electronic components (120, 220, 620) mounted on the deformable substrate to at least one of:
one or more other electronic components (120, 220, 620) mounted on the deformable substrate, and
one or more other electronic components (120, 220, 620) mounted on another connected substrate; and
wherein the one or more substrate electronic components are mounted on the deformable substrate by an interconnect, the interconnect configured to electrically and mechanically interconnect the one or more substrate electronic components to the deformable substrate;
wherein the interconnect comprises an ion gel (110, 210, 410a, 410b, 510a, 510b, 610, 910), the ion gel configured to:
electrically interconnect the one or more substrate electronic components to the deformable substrate by capacitive coupling;
mechanically interconnect the one or more substrate electronic components to the deformable substrate by adhesion, and
maintain the electrical and mechanical interconnection of the one or more substrate electronic components under operational strains of the deformable substrate.

2. The apparatus of claim 1, wherein one or more of the electrical interconnect and the deformable substrate are configured to accommodate strains of up to 1-5%, 10%, 15%, 20%, 25%, 30%, 40%, 50%, 75%, 100%, 150% or 200% under operational conditions.

3. The apparatus of claim 2, wherein the operational strains comprise one or more of:
flexure providing for a radius of curvature of at least a portion of the deformable substrate, the radius of curvature being less than 5mm, 10mm, 15mm, 20mm, 25mm, 30mm, 35mm, 40mm, 45mm, 50mm, 55mm and 60mm upto 300mm;
stretching of at least a portion of the deformable substrate, the stretching being up to 1-5%, 10%, 15%, 25%, 30% of the un-stretched length of the deformable substrate; and
compression of at least a portion of the deformable substrate, the compression being up to 5%, 10%, 15%, 25%, 30% of the uncompressed length of the deformable substrate.

4. The apparatus of claim 1, wherein the deformable substrate comprises at least one surface recess (330a, 330b, 430a, 430b, 530a, 530b), the at least one surface recess configured to facilitate operational strains of the deformable substrate by respective opening and closing of the at least one surface recess under operational strains.

5. The apparatus of claim 4, wherein the ion gel is configured to span from a first side of the surface recess to the second opposing side of the surface recess.

6. The apparatus of claim 5, wherein the ion gel is configured to one of at least partially infill the surface recess or span across the surface recess without partially infilling the surface recess.

7. The apparatus of claim 1, wherein one or more of a region of the deformable substrate underlying the substrate electronic component and the substrate electronic component as well as the ion gel interconnect is at least partially optically transparent.

8. The apparatus of claim 1, wherein the deformable substrate comprises an electrically conductive track (104, 106, 204, 604, 622) configured to enable the electrical connection, the electrically conductive track comprising one or more of graphene and carbon nanotubes.

9. The apparatus of claim 1, wherein the ion gel comprises an ionic liquid and a polymer, the ionic liquid comprising one or more of 1-ethyl-3-methylimidazolium bis(trifluoromethylsulfonyl)imide, [EMIM][TFSI], [BMIM][PF6], and [EMIM][OctOSO3, and the polymer comprising one or more of PS PMMA PS triblock copolymer or PS-PEO-PS (triblock copolymer, poly(styrene-block-ethylene oxide-block-styrene)).

10. The apparatus of claim 1, wherein the ion gel has a viscosity in the range of 1 mPas to 10000 cPas under operational conditions.

11. The apparatus of claim 1, wherein the electrical interconnection of the ion gel to the deformable substrate or the substrate electronic component comprises a specific capacitance greater than 1µF/cm², up to 50 to 300µF/cm².

12. The apparatus of claim 1, wherein the substrate electronic component comprises one or more of:
a sensor (624) configured to provide sensor signalling based on the electrical impedance of the sensor;
a rectifier configured to receive alternating current from the interconnect by capacitive coupling and to provide direct current to an electronic component.

13. The apparatus of claim 1, further comprising a substrate interconnect (910), the substrate interconnect configured to electrically and mechanically interconnect another substrate (960) to the deformable substrate (902), wherein the substrate interconnect comprises an ion gel, the ion gel configured to:
electrically interconnect the other substrate to the deformable substrate by capacitive coupling;
mechanically interconnect the other substrate to the deformable substrate by adhesion, and
maintain the electrical and mechanical interconnection of the respective substrates under operational strains of one or more of the deformable substrate and the other substrate.

14. A method comprising:
providing an apparatus by mounting one or more substrate electronic components (120, 220) to a deformable substrate (102, 202, 300a, 300b, 400a, 400b, 500a, 500b, 602, 902) by using an ion gel interconnect, the ion gel interconnect (110, 210, 410a, 410b, 510a, 510b, 610, 910) configured to electrically and mechanically interconnect the one or more substrate electronic components to the deformable substrate,
wherein the substrate is configured to allow for electrical connection of the one or more substrate electronic components mounted on the deformable substrate to at least one of:
one or more other electronic components (120, 220, 620) mounted on the deformable substrate, and
one or more other electronic components (120, 220, 620) mounted on another connected substrate;
and the ion gel is configured to:
electrically interconnect the one or more substrate electronic components to the deformable substrate by capacitive coupling;
mechanically interconnect the one or more substrate electronic components to the deformable substrate by adhesion, and
maintain the electrical and mechanical interconnection of the one or more substrate electronic components under operational strains of the deformable substrate.

15. A computer program comprising computer code configured to perform the method of claim 14.

## Patentansprüche

1. Vorrichtung, welche Folgendes umfasst:
ein verformbares Substrat (102, 202, 300a, 300b, 400a, 400b, 500a, 500b, 602, 902), wobei das Substrat dafür ausgelegt ist, eine elektrische Verbindung einer oder mehrerer elektronischer Substratkomponenten (120, 220, 620), die auf dem verformbaren Substrat montiert sind, mit wenigstens einer der folgenden zu ermöglichen:
einer oder mehreren anderen elektronischen Komponenten (120, 220, 620), die auf dem verformbaren Substrat montiert sind, und
einer oder mehreren anderen elektronischen Komponenten (120, 220, 620), die auf einem anderen verbundenen Substrat montiert sind, und
wobei die eine oder die mehreren elektronischen Substratkomponenten durch eine Zwischenverbindung auf dem verformbaren Substrat montiert sind, wobei die Zwischenverbindung dafür ausgelegt ist, die eine oder die mehreren elektronischen Substratkomponenten elektrisch und mechanisch mit dem verformbaren Substrat zu verbinden,
wobei die Zwischenverbindung ein Ionengel (110, 210, 410a, 410b, 510a, 510b, 610, 910) umfasst, wobei das Ionengel dafür ausgelegt ist, Folgendes auszuführen:
elektrisches Verbinden der einen oder der mehreren elektronischen Substratkomponenten mit dem verformbaren Substrat durch kapazitive Kopplung,
mechanisches Verbinden der einen oder der mehreren elektronischen Substratkomponenten mit dem verformbaren Substrat durch Haftung und
Beibehalten der elektrischen und mechanischen Zwischenverbindung der einen oder der mehreren elektronischen Substratkomponenten unter Betriebsdeformationen des verformbaren Substrats.

2. Vorrichtung nach Anspruch 1, wobei eine oder mehrere von der elektrischen Zwischenverbindung und dem verformbaren Substrat dafür ausgelegt sind, Deformationen von bis zu 1 - 5 %, 10 %, 15 %, 20 %, 25 %, 30 %, 40 %, 50 %, 75 %, 100 %, 150 % oder 200 % unter Betriebsbedingungen auszuhalten.

3. Vorrichtung nach Anspruch 2, wobei die Betriebsdeformationen eine oder mehrere der folgenden umfassen:
eine Biegung, die einen Krümmungsradius wenigstens eines Teils des verformbaren Substrats bereitstellt, wobei der Krümmungsradius kleiner als 5 mm, 10 mm, 15 mm, 20 mm, 25 mm, 30 mm, 35 mm, 40 mm, 45 mm, 50 mm, 55 mm und 60 mm bis zu 300 mm beträgt,
eine Dehnung wenigstens eines Teils des verformbaren Substrats, wobei die Dehnung bis zu 1 - 5 %, 10 %, 15 %, 25 %, 30 % der ungedehnten Länge des verformbaren Substrats beträgt, und
eine Kompression wenigstens eines Teils des verformbaren Substrats, wobei die Kompression bis zu 5 %, 10 %, 15 %, 25 %, 30 % der unkomprimierten Länge des verformbaren Substrats beträgt.

4. Vorrichtung nach Anspruch 1, wobei das verformbare Substrat wenigstens eine Oberflächenvertiefung (330a, 330b, 430a, 430b, 530a, 530b) umfasst, wobei die wenigstens eine Oberflächenvertiefung dafür ausgelegt ist, Betriebsdeformationen des verformbaren Substrats durch Öffnen bzw. Schließen der wenigstens einen Oberflächenvertiefung unter Betriebsdeformationen zu erleichtern.

5. Vorrichtung nach Anspruch 4, wobei das Ionengel dafür ausgelegt ist, sich von einer ersten Seite der Oberflächenvertiefung zur zweiten entgegengesetzten Seite der Oberflächenvertiefung zu erstrecken.

6. Vorrichtung nach Anspruch 5, wobei das Ionengel dafür ausgelegt ist, zumindest teilweise die Oberflächenvertiefung zu füllen und/oder sich über die Oberflächenvertiefung zu erstrecken, ohne die Oberflächenvertiefung teilweise zu füllen.

7. Vorrichtung nach Anspruch 1, wobei eines oder mehrere von einem Gebiet des verformbaren Substrats, das unter der elektronischen Substratkomponente liegt, und der elektronischen Substratkomponente sowie von der Ionengelzwischenverbindung zumindest teilweise optisch transparent ist.

8. Vorrichtung nach Anspruch 1, wobei das verformbare Substrat eine elektrisch leitende Bahn (104, 106, 204, 604, 622) umfasst, die dafür ausgelegt ist, die elektrische Verbindung zu ermöglichen, wobei die elektrisch leitende Bahn eines oder mehrere von Graphen und Kohlenstoffnanoröhrchen umfasst.

9. Vorrichtung nach Anspruch 1, wobei das Ionengel eine ionische Flüssigkeit und ein Polymer umfasst, wobei die ionische Flüssigkeit eines oder mehrere von 1-Ethyl-3-methylimidazolium bis(trifluormethylsulfonyl)imid, [EMIM][TFSI], [BMIM] [PF6] und [EMIM] [OctOS03 umfasst und das Polymer eines oder mehrere von einem PS-PMMA-PS-Triblockcopolymer oder PS-PEO-PS (Triblockcopolymer, Poly(styrol-Block-Ethylenoxid-Block-Styrol)) umfasst.

10. Vorrichtung nach Anspruch 1, wobei das Ionengel unter Betriebsbedingungen eine Viskosität im Bereich von 1 mPas bis 10000 cPas aufweist.

11. Vorrichtung nach Anspruch 1, wobei die elektrische Zwischenverbindung des Ionengels zum verformbaren Substrat oder zu der elektronischen Substratkomponente eine spezifische Kapazität von mehr als 1 µF/cm² und bis zu 50 bis 300 µF/cm² aufweist.

12. Vorrichtung nach Anspruch 1, wobei die elektronische Substratkomponente einen oder mehrere der folgenden umfasst:
einen Sensor (624), der dafür ausgelegt ist, eine Sensorsignalisierung auf der Grundlage der elektrischen Impedanz des Sensors bereitzustellen,
einen Gleichrichter, der dafür ausgelegt ist, durch kapazitive Kopplung einen Wechselstrom von der Zwischenverbindung zu empfangen und einer elektronischen Komponente einen Gleichstrom bereitzustellen.

13. Vorrichtung nach Anspruch 1, welche ferner eine Substratzwischenverbindung (910) umfasst, wobei die Substratzwischenverbindung dafür ausgelegt ist, ein anderes Substrat (960) elektrisch und mechanisch mit dem verformbaren Substrat (902) zu verbinden, wobei die Substratzwischenverbindung ein Ionengel umfasst, wobei das Ionengel dafür ausgelegt ist, Folgendes auszuführen:
elektrisches Verbinden des anderen Substrats mit dem verformbaren Substrat durch kapazitive Kopplung,
mechanisches Verbinden des anderen Substrats mit dem verformbaren Substrat durch Haftung und
Beibehalten der elektrischen und mechanischen Zwischenverbindung der jeweiligen Substrate unter Betriebsdeformationen eines oder mehrerer vom verformbaren Substrat und vom anderen Substrat.

14. Verfahren, welches Folgendes umfasst:
Bereitstellen einer Vorrichtung durch Montieren einer oder mehrerer elektronischer Substratkomponenten (120, 220) auf einem verformbaren Substrat (102, 202, 300a, 300b, 400a, 400b, 500a, 500b, 602, 902) unter Verwendung einer Ionengelzwischenverbindung, wobei die Ionengelzwischenverbindung (110, 210, 410a, 410b, 510a, 510b, 610, 910) dafür ausgelegt ist, die eine oder die mehreren elektronischen Substratkomponenten elektrisch und mechanisch mit dem verformbaren Substrat zu verbinden,
wobei das Substrat dafür ausgelegt ist, eine elektrische Verbindung der einen oder der mehreren auf dem verformbaren Substrat montierten elektronischen Substratkomponenten mit wenigstens einer der folgenden zu ermöglichen:
einer oder mehreren anderen elektronischen Komponenten (120, 220, 620), die auf dem verformbaren Substrat montiert sind, und
einer oder mehreren anderen elektronischen Komponenten (120, 220, 620), die auf einem anderen verbundenen Substrat montiert sind,
und wobei das Ionengel dafür ausgelegt ist, Folgendes auszuführen:
elektrisches Verbinden der einen oder der mehreren elektronischen Substratkomponenten mit dem verformbaren Substrat durch kapazitive Kopplung,
mechanisches Verbinden der einen oder der mehreren elektronischen Substratkomponenten mit dem verformbaren Substrat durch Haftung und
Beibehalten der elektrischen und mechanischen Zwischenverbindung der einen oder der mehreren elektronischen Substratkomponenten unter Betriebsdeformationen des verformbaren Substrats.

15. Computerprogramm, das Computercode umfasst, der dafür ausgelegt ist, das Verfahren nach Anspruch 14 auszuführen.

## Revendications

1. Appareil comprenant:
un substrat déformable (102, 202, 300a, 300b, 400a, 400b, 500a, 500b, 602, 902), le substrat étant configuré de manière à permettre une connexion électrique d'un ou de plusieurs composant(s) électronique(s) de substrat (120, 220, 620) monté(s) sur le substrat déformable sur au moins un parmi:
un ou plusieurs autre(s) composant(s) électronique(s) (120, 220, 620) monté(s) sur le substrat déformable, et
un ou plusieurs autre(s) composant(s) électronique (s) (120, 220, 620) monté (s) sur un autre substrat connecté; et
dans lequel lesdits un ou plusieurs composant(s) électronique(s) de substrat sont montés sur le substrat déformable par une interconnexion, l'interconnexion étant configurée de manière à interconnecter de façon électrique et mécanique lesdits un ou plusieurs composant(s) électronique(s) de substrat au substrat déformable;
dans lequel l'interconnexion comprend un gel ionique (110, 210, 410a, 410b, 510a, 510b, 610, 910), le gel ionique étant configuré de manière à:
interconnecter électriquement lesdits un ou plusieurs composant(s) électronique(s) de substrat au substrat déformable par un couplage capacitif;
interconnecter mécaniquement lesdits un ou plusieurs composant(s) électronique(s) de substrat au substrat déformable par adhésion; et
maintenir l'interconnexion électrique et mécanique desdits un ou plusieurs composant(s) électronique(s) de substrat sous des déformations opérationnelles du substrat déformable.

2. Appareil selon la revendication 1, dans lequel un ou plusieurs parmi l'interconnexion électrique et le substrat déformable est (son)t configuré(s) de manière à subir des déformations jusqu'à 1 % à 5 %, 10 %, 15 %, 20 %, 25 %, 30 %, 40 %, 50 %, 75 %, 100 %, 150 % ou 200 % sous des conditions opérationnelles.

3. Appareil selon la revendication 2, dans lequel les déformations opérationnelles comprennent une ou plusieurs action(s) parmi:
une flexion fournissant un rayon de courbure d'au moins une partie du substrat déformable, le rayon de courbure étant inférieur à 5 mm, 10 mm, 15 mm, 20 mm, 25 mm, 30 mm, 35 mm, 40 mm, 45 mm, 50 mm, 55 mm et 60 mm jusqu'à 300 mm;
un étirement d'au moins une partie du substrat déformable, ledit étirement pouvant atteindre jusqu'à 1 % à 5 %, 10 %, 15 %, 25 %, 30 % de la longueur non étirée du substrat déformable; et
une compression d'au moins une partie du substrat déformable, la compression pouvant atteindre jusqu'à 5 %, 10 %, 15 %, 25 %, 30 % de la longueur non comprimée du substrat déformable.

4. Appareil selon la revendication 1, dans lequel le substrat déformable comprend au moins un évidement de surface (330a, 330b, 430a, 430b, 530a, 530b), ledit au moins un évidement de surface étant configuré de manière à faciliter des déformations opérationnelles du substrat déformable par une ouverture et une fermeture respectives dudit au moins un évidement de surface sous des déformations opérationnelles.

5. Appareil selon la revendication 4, dans lequel le gel ionique est configuré de manière à s'étendre à partir d'un premier côté de l'évidement de surface jusqu'au second côté opposé de l'évidement de surface.

6. Appareil selon la revendication 5, dans lequel le gel ionique est configuré de manière à remplir au moins partiellement l'évidement de surface ou s'étendre à travers l'évidement de surface sans remplir partiellement l'évidement de surface.

7. Appareil selon la revendication 1, dans lequel un ou plusieurs parmi une région du substrat déformable sous-jacente aux composants électroniques de substrat et les composants électroniques de substrat ainsi que l'interconnexion par gel ionique est au moins partiellement optiquement transparent.

8. Appareil selon la revendication 1, dans lequel le substrat déformable comprend une piste électriquement conductrice (104, 106, 204, 604, 622) configurée de manière à permettre la connexion électrique, la piste électriquement conductrice comprenant un ou plusieurs nanotube(s) de graphène et de carbone.

9. Appareil selon la revendication 1, dans lequel le gel ionique comprend un liquide ionique et un polymère, le liquide ionique comprenant un ou plusieurs composant(s) parmi le 1-éthyl-3-méthylimidazolium bis (trifluoro méthylsulfonyl)imide, le [EMIM] [TFSI], le [BMIM][PF6] et le [EMIM][OctOS03], et le polymère comprenant un ou plusieurs composant(s) parmi le PS PMMA PS copolymère tribloc ou le PS-PEO-PS (copolymère tribloc, le poly(styrène-bloc-éthylène oxyde-bloc-styrène)).

10. Appareil selon la revendication 1, dans lequel le gel ionique présente une viscosité comprise dans la gamme de 1 mPas à 10000 cPas sous des conditions opérationnelles.

11. Appareil selon la revendication 1, dans lequel l'interconnexion électrique par gel ionique au substrat déformable ou aux composants électroniques de substrat présente une capacitance spécifique supérieure à 1 µF/cm², jusqu'à 50 à 300 µF/cm².

12. Appareil selon la revendication 1, dans lequel les composants électroniques de substrat comprennent un ou plusieurs composant(s) parmi:
un capteur (624) configuré de manière à générer une signalisation de capteur sur la base de l'impédance électrique du capteur; et
un redresseur configuré de manière à recevoir du courant alternatif en provenance de l'interconnexion par un couplage capacitif et à fournir du courant continu à un composant électronique.

13. Appareil selon la revendication 1, comprenant en outre une interconnexion de substrats (910), l'interconnexion de substrats étant configurée de manière à interconnecter de façon électrique et mécanique un autre substrat (960) au substrat déformable (902), dans lequel l'interconnexion de substrats comprend un gel ionique, le gel ionique étant configuré de manière à:
interconnecter électriquement l'autre substrat au substrat déformable par un couplage capacitif;
interconnecter mécaniquement l'autre substrat au substrat déformable par adhésion; et
maintenir l'interconnexion électrique et mécanique des substrats respectifs sous des déformations opérationnelles d'un ou de plusieurs parmi le substrat déformable et l'autre substrat.

14. Procédé, comprenant les étapes suivantes:
former un appareil en montant un ou plusieurs composant(s) électronique(s) de substrat (120, 220) sur un substrat déformable (102, 202, 300a, 300b, 400a, 400b, 500a, 500b, 602, 902) en utilisant une interconnexion par gel ionique, l'interconnexion par gel ionique (110, 210, 410a, 410b, 510a, 510b, 610, 910) étant configurée de manière à interconnecter de façon électrique et mécanique lesdits un ou plusieurs composant(s) électronique(s) de substrat au substrat déformable,
dans lequel le substrat est configuré de manière à permettre une connexion électrique desdits un ou plusieurs composant(s) électronique(s) de substrat monté(s) sur le substrat déformable à au moins un parmi:
un ou plusieurs autre(s) composant(s) électronique(s) (120, 220, 620) monté(s) sur le substrat déformable, et
un ou plusieurs autre(s) composant(s) électronique (s) (120, 220, 620) monté (s) sur un autre substrat connecté;
et le gel ionique est configuré de manière à:
interconnecter électriquement lesdits un ou plusieurs composant(s) électronique(s) de substrat au substrat déformable par un couplage capacitif;
interconnecter mécaniquement lesdits un ou plusieurs composant(s) électronique(s) de substrat au substrat déformable par adhésion; et
maintenir l'interconnexion électrique et mécanique desdits un ou plusieurs composant(s) électronique(s) de substrat sous des déformations opérationnelles du substrat déformable.

15. Programme d'ordinateur comprenant un code informatique configuré de manière à exécuter le procédé selon la revendication 14.
